Europäisches Patentamt

European Patent Office

Office européen des brevets

(11) Publication number: **0 042 581**
**B1**

(12) **EUROPEAN PATENT SPECIFICATION**

(45) Date of publication of patent specification: **30.12.86**

(51) Int. Cl.⁴: **H 01 L 27/02, H 02 H 7/20**

(21) Application number: **81104648.1**

(22) Date of filing: **16.06.81**

(54) Integrated circuit.

(30) Priority: **17.06.80 JP 81624/80**

(43) Date of publication of application:
**30.12.81 Bulletin 81/52**

(45) Publication of the grant of the patent:
**30.12.86 Bulletin 86/52**

(84) Designated Contracting States:
**DE GB**

(56) References cited:
**FR-A-2 342 557**
**US-A-3 739 238**
**US-A-3 746 946**

(73) Proprietor: **NEC CORPORATION**
**33-1, Shiba 5-chome, Minato-ku**
**Tokyo 108 (JP)**

(72) Inventor: **Natsui, Yoshinobu**
**c/o Nippon Electric Co., Ltd. 33-1, Shiba**
**Gochome**
**Minato-ku Tokyo (JP)**

(74) Representative: **Glawe, Delfs, Moll & Partner**
**Patentanwälte**
**Postfach 26 01 62 Liebherrstrasse 20**
**D-8000 München 26 (DE)**

Courier Press, Leamington Spa, England.

# Description

The present invention relates to an integrated circuit, and more particularly to protective means for preventing electrostatic breakdown of a monolithic integrated circuit (hereinafter abbreviated as IC).

The progress of the IC and LSI (Large Scale IC) is remarkable, and in these only 30 years since the invention of the transistor they have been quickly popularized in every field of the consumer uses and industrial uses. As one of big reasons for this popularization it is pointed out that the use of IC's has brought about reduction of a number of parts or a number of terminals to be equipped in an electronic instrument or system and thereby has contributed to great enhancement of a reliability of the instrument or system. On the other hand, however, as a result of the use of IC's, a reliability of an instrument or system has become largely dependent upon a reliability of IC's, and hence, a demand for enhancement of a reliability of IC's has become more and more severe. In the mechanisms of faults of IC's are involved various problems such as deterioration due to invasion of moisture, breaking of wire connections or increase in a leakage current caused by defects in a diffusion process, but owing to efforts of IC manufacturers, most of the problems have been resolved. One of the big problems which remain unsolved is breakdown or destruction of IC by static electricity.

Breakdown of an IC caused by static electricity means the phenomenon that static electricity charged on the human body and tools or jigs placed around on IC such as a jig used during a mounting process of an IC chip, a conveying carrier, and a jig for test and measurement of IC may possibly discharge between terminals of an IC which is brought close to or in contact with the charged body, resulting in breakdown of an internal element of the IC. The problem of breakdown of an IC by static electricity has been closed up by two causes. One is the progress of high degree of integration of LSI's, as a result of which a pattern of a LSI has become extremely fine and apt to be destroyed by static electricity. The other cause is the large variety of the utilization conditions of IC's. In other words, IC's have been applied to every field of applications, especially to portable electronic instruments, and petrochemical products have increased in the living environment, so that a chance of interference between static electricity and IC's has remarkably enhanced.

Heretofore, in the technique for protecting an IC from electrostatic destruction, use has been made of a method of serially inserting a resistor between an external terminal and an input circuit element to attenuate static electricity applied to the external terminal, or a method of providing a diode between an input terminal and the ground potential to by-pass an abnormal voltage caused by static electricity to the ground potential. However, the method of employing a resistor has a shortcoming that an inherent input signal level would be necessarily attenuated.

On the other hand, in the method of employing a diode, since the diode is necessitated to have a capability of withstanding against by-passing of electrostatic energy, a diode having large configuration and size becomes necessary. In addition, such diode having large configuration and size naturally has a large junction capacitance, and consequently, undesirable delay of an input signal level and change of a waveform would occur.

An integrated circuit according to the preamble of the claim is known from US—A—37 39 238.

However, this integrated circuit still needs a further clamping diode when used at the input of a diode transistor logic (DTL) or transisted transistor logic (TTL). Clamping diodes in DTL- or TTL-circuits are general standard.

It is an object of the present invention to provide in an integrated circuit an electrostatic protection circuit, which needs no separately provided input clamping diode when used at the input of a DTL- or TTL-circuit.

This object according to the invention is solved by the features in the preamble of claim 1 and by the feature that said collector region forms a PN-junction with the substrate to form a clamping diode connected in parallel to said bipolar transistor.

The protective circuit according to the present invention is applicable not only to an integrated circuit including bipolar transistors but also to an integrated circuit including field effect transistors.

The above-mentioned and other objects, features and advantages of the embodiments of the present invention will become more apparent with reference to the following description of preferred embodiments of the invention taken in conjunction with the accompanying drawings, wherein:

Figs. 1(a) to 1(e) are block diagrams showing integrated circuits in the prior art,

Fig. 2 is a block diagram of a further conventional integrated circuit,

Figure 3 is a cross-section view showing one example of a semiconductor structure of the input protective circuit according to the present invention,

Fig. 4 is an equivalent circuit diagram of the input protective circuit shown in Fig. 3,

Fig. 5 is a diagram showing the operation characteristics of the input protective circuit according to the present invention as compared to those of the input protective circuit in the prior art,

Fig. 6 is a circuit diagram to be used for explaining the function of an input protective circuit,

Fig. 7 is a diagram showing a discharge characteristic in the circuit shown in Fig. 6,

Fig. 8 is a diagram showing discharge characteristics of the input protective circuit consisting of a diode or of a base-opened transistor (CEO),

Fig. 9 shows the compensation of a leakage current through a C—B junction of a transistor by a protective resistor,

Figs. 10 to 15 are circuit diagrams showing various practical embodiments of the present invention.

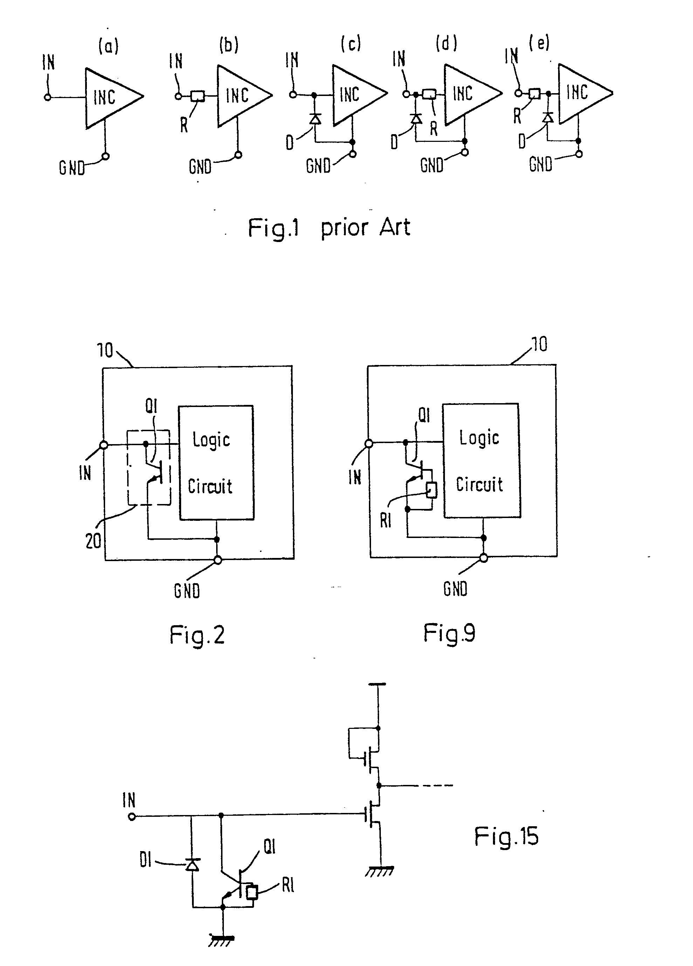

A countermeasure for preventing destruction of IC's caused by static electricity has been heretofore investigated. Fig. 1 shows a number of examples of the heretofore taken countermeasure. Fig. 1(a) shows the case where no measure is taken for an input circuit INC. In general, as shown in Figs. 1(b) to 1(e) a method of serially inserting a resistor R on the side of an input circuit INC within an IC, a method of adding a diode D in parallel to the input circuit INC, or a method of adding a series resistor R and a parallel diode D in combination, has been employed. More particularly, Fig. 1(b) shows the case where a resistor R is serially inserted between an input terminal IN and an input end of the circuit INC. Fig. 1(c) shows the case where a diode D is added in parallel across an input end of the circuit INC. Fig. 1(d) shows the case where a resistor R is serially inserted between an input terminal IN and an input end of the circuit INC and further a diode D is added in parallel across the resistor R and the input end of the circuit INC. Fig. 1(e) shows the case where a diode D is added in parallel across an input end of the input circuit INC and further a resistor R is serially inserted between an input terminal and the input end of the circuit INC. In any one of these method, electrostatic energy applied to an IC is mostly dissipated by the inserted resistor R and/or mostly by-passed through the added diode D by making use of breakdown of the diode, and thereby energy dissipation within the IC can be minimized, Therefore, these prior art techniques brought about considerable effects for preventing breakdown of an IC caused by static electricity.

However, these protective circuits against electrostatic destruction still involve a number of problems. At first, with regard to the method of serially inserting the resistor R, unless the resistor R has a large resistance to a certain extent, great enhancement of an electrostatic withstand voltage cannot be expected. On the other hand if a large resistance is selected, degradation of various AC characteristics would be resulted. Also, with regard to the method of adding the diode D in parallel, though it is not so serious if the diode is added externally of an IC, in the case of providing the diode within an IC, dimensional restriction to the diode would become severe. Since the latter method aims at absorbing most the electrostatic energy by making use of a breakdown characteristic of the diode and thereby reducing energy dissipation in the principal circuit, heat generation in the added diode per se comes into question, and hence a considerably large-sized diode must be used so that the protective circuit itself may not be destroyed by this heat generation. However, a cost of an IC chip is approximately proportional to the chip size, and therefore, it is not allowed to use a large chip area for a protective circuit which does not achieve a principal circuit function of the IC. Moreover, it is an unfavorable trend in view of increase of a terminal capacitance to excessively enlarge an element in a protective circuit against electrostatic destruction.

In general, an electrostatic protective circuit making use of a backward breakdown characteristic of a diode has been widely used, and in the case of a bipolar type IC structure, a Schottky barrier diode (SBD), an emitter-base junction diode (E—B diode), a collector-base junction diode (C—B diode) and the like are employed. Here, making consideration on the modes electrostatic destruction of bipolar type IC's which have been commercially available so far, the IC having the weakest durability against electrostatic rupture is that have a Schottky barrier type diode structure. This is due to the fact that since SBD is generally used for a super high frequency, it has a small junction area and a thin barrier layer and consequently heat generation is apt to localize. Short-circuiting of an E—B junction of a transistor would occur next frequently, and breakdown of a C—B junction of a low withstand voltage transistor would occur at the next order of frequency. Accordingly, as a diode to be used for the purpose of electrostatic protection, the Schottky barrier diode and the E—B diode are not suitable because inherently they themselves have a weak durability against electrostatic destruction. Whereas, in the case of a protective circuit element making use of a C—B junction, the electrostatic durability of the element itself can be made fairly strong by enlarging the size of the element, and hence, it can achieve a fairly excellent effect as a by-passing diode for electrostatic energy. However, a breakdown voltage point of the C—B junction is far higher than that of the E—B junction that is apt to break down in a principal circuit, and thus the internal resistance after breakdown of the protective circuit element cannot be made as low as desirable within a limited element size. Therefore, although the durability against electrostatic destruction of the element per se is strong, with respect to the by-passing effect for electrostatic energy it seems to be not yet satisfactory.

Fig. 2, shows a further conventional protective circuit. Between an input terminal IN and a ground terminal GND within an IC chip 10 is added a base-opened transistor Ql having a collector connected to the input terminal IN and an emitter connected to the ground terminal GND. This additional circuit 20 forms a protective circuit for by-passing electrostatic energy applied to the input terminal IN by making use of the collector-emitter breakdown characteristic of the base-opened transistor (the so-called $BV_{CEO}$).

Now description will be made in detail on preferred embodiments of the present invention with reference to the accompanying drawings.

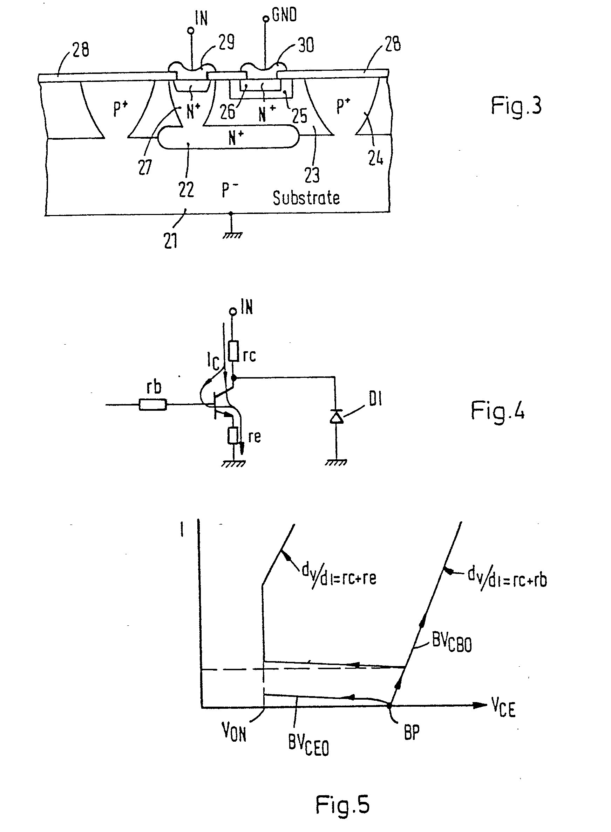

An embodiment of the protective circuit according to the present invention will be explained in detail with reference to Figs. 3 to 5. In Fig. 3 the input protective section per se has an integrated NPN transistor structure. In a surface portion of a P-type silicon substrate 21 is provided an $N^+$-type buried layer 22. An N-type epitaxial layer is delimited by a P-type isolation region 24 to form a collector region 23. In the collector region 23 are successively formed a P-type base region 25 and an N-type emitter region 26. In addition, an $N^+$-type collector contact region 27 is formed in the collector region 23 so as to contact with the $N^+$-type burried layer 22. The contact region 27 contributes to reduction of a collector resistance. Collector and emitter electrodes 29 and 30 make contact with the respective regions 27 and 26 through apertures in a silicon oxide layer 28.

In the equivalent circuit shown in Fig. 4, reference symbols $r_c$, $r_b$ and $r_e$ designate internal resistances of the collector, base and emitter, respectively, and a reference symbol DI designates a diode formed between the substrate and the collector that intervenes as a parasitic element between the ground and the collector in an integrated circuit structure. In a monolithic integrated circuit structure, it is necessary to hold the P-type substrate at the lowest potential, for instance, in a DTL or TTL it is necessary to hold the P-type substrate at the ground potential, and in an ECL it is necessary to hold the P-type substrate at a negative source potential (for example, at −5.2V). Accordingly, the parasitic junction diode DI would necessarily have its positive pole connected to the ground potential and its negative pole connected to the collector. This parasitic diode DI has a high breakdown voltage and its terminal voltage is suppressed to a low value after actuation of the transistor DI. As described later, this parasitic diode DI can be made to have the function of a clamping diode.

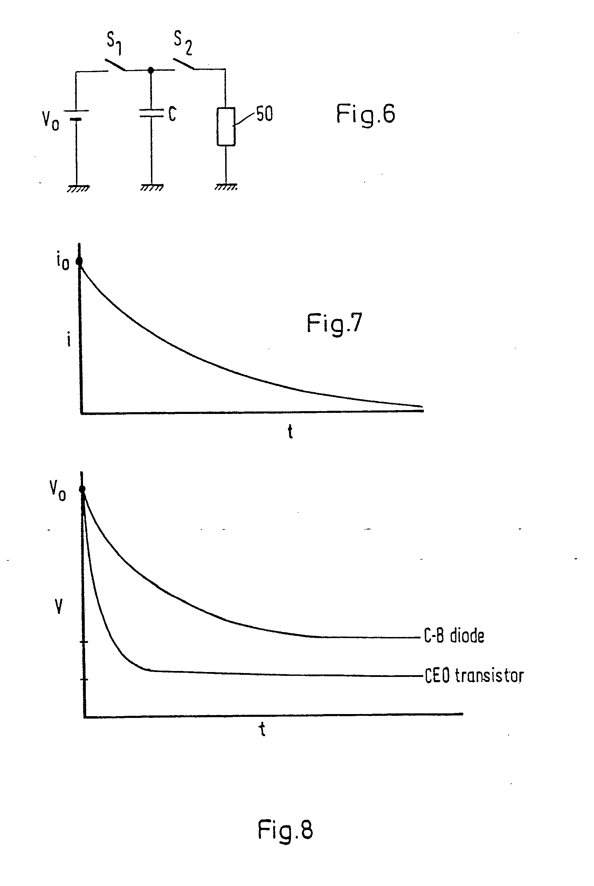

In the equivalent circuit shown in Fig. 4, a voltage-current characteristic as viewed from the collector side is represented by a curve $BV_{CEO}$ having a negative resistance as shown in Fig. 5. With regard to this curve $BV_{CEO}$, description will be made in more detail. Assuming now that a large voltage has been applied to the collector, then at first the collector-base path (hereinafter called simply C—B) would break down at a breakdown point BP due to an avalanche effect. Then owing to the fact that this breakdown current flows through the base-emitter path (hereinafter called simply B—E) to the ground GND, a current that is $h_{fe}$ times as large as this breakdown current flows to the ground GND through the collector-emitter path (hereinafter called simply C—E). Furthermore, owing to the fact that a part of this $h_{fe}$-folded current flows through the B—E, it is further multiplied by a factor of $h_{fe}$ and hence the current flowing through the C—E is more and more increased. In other words, the initial C—B breakdown current triggers a transistor action of the base-opened transistor and the transistor is held latched under a positive feedback condition. Then, since the collector potential falls abruptly to a settled voltage $V_{ON}$ by the transistor action, the behavior as represented by the negative resistance curve $BV_{CEO}$ shown in Fig. 5 is obtained.

The electrostatic protection according to the present invention really utilizes this characteristic represented by the curve $BV_{CEO}$. In contrast to this $BV_{CEO}$ characteristic, as one of the heretofore known examples of electrostatic protection, a protective circuit making use of the breakdown characteristic of the C—B junction has been known, and the latter characteristic is represented by a curve $BV_{CBO}$ in Fig. 5. This characteristic is a voltage-current characteristic as viewed from the collector side upon connecting the base to the emitter. Assuming now that a high voltage has been applied to the collector, at first the C—B junction breaks down, and thereafter the voltage is increased with a gradient equal to an internal resistance $r_c+r_b$ of the C—B. Of course, a negative resistance characteristic similar to the curve $BV_{CEO}$ is not presented because a transistor action would not occur.

Now, with respect to preference in the durability against a high voltage or a heavy current as is the case with static electicity, comparison will be made between a transistor having a CEO structure and a C—B junction diode.

At first, static electric charge is represented by a model illustrated in Fig. 6. Under the condition where a switch $S_1$ is closed, an electric charge $Q_0=CV_0$ is stored in a capacitor C. Subsequently, when the switch $S_1$ is opened and the other switch $S_2$ is closed, the charge $Q_0$ is discharged through an electrostatic protective element 50 on the side of the device as shown in Fig. 7.

Now, further description will be made, assuming practical numerical values for the respective parameters appearing in the characteristic curves shown in Fig. 5. As one example of the transistor characteristics, let us assume the following values which are of the normally conceivable order:

BP=40V (breakdown point)
$V_{ON}$=20V (settled voltage immediately after breakdown on the $BV_{CEO}$)

$$r_c=10\Omega, \ r_b=50\Omega \ \text{and} \ r_e=2\Omega.$$

Then, in contrast to the time constant of the C—B diode of

$$T_1=C\times(10\Omega+50\Omega),$$

the time constant of the CEO transistor is

$$T_2=C\times(10\Omega+2\Omega),$$

and therefore, the latter can complete discharge within about 1/5 times as small as the period required for the former as shown in Fig. 7. With regard to an electric power dissipated within an electrostatic protective element also, in contrast to the power dissipation in the case of the C—B diode of:

$$P_1 = BP \cdot i + (r_c + r_b)i^2 = 40i + 60i^2,$$

the power dissipation in the case of the CEO structure transistor is far smaller as represented by:

$$P_2 = V_{ON} \cdot i + (r_c + r_e)i^2 = 20i + 12i^2.$$

As described above, as compared to the C—B diode, the CEO structure transistor has a very strong durability against static electricity because heat generation caused by power dissipation within an element is far less for the latter. Since the quantity of heat generated within an element is mostly due to the heat generation at the B—C junction (~20V) rather than at the B—E junction (~1V), the durability against static electricity is determined by the area of the B—C junction.

Accordingly, if a junction area of a B—C diode and a B—C junction area of a CEO structure transistor is the same, then the CEO structure transistor has a far stronger durability against static electricity. On the contrary, if it is intended to realize a durability against static electricity compatible to that of a CEO structure transistor by utilizing a B—C diode, then it is compelled to disperse heat generation by enlarging the B—C junction area. Therefore, on the basis of the above-described simplified calculation, a B—C junction area that is 5 times as large as that of the CEO structure transistor is necessitated, and even if the practical values of the parameters BP, $V_{ON}$, $r_c$, $r_b$ and $r_e$ in the transistor characteristics are taken into consideration in the protecting process, a B—C junction area that is 2~4 times as large as that of the CEO structure transistor is necessitated. Thus the use of a B—C diode is disadvantageous in view of the size of the protective element.

As described above, a further improvement of the heretofore known electrostatic protective element for overcoming the above-described shortcomings of the E—B junction or C—B junction diode is the use of the base-opened C—E structure (CEO structure) transistor according to the present invention. As is well known, a C—E breakdown point of a transistor is lower than a breakdown point of the C—B junction of the same transistor, and moreover a voltage-current characteristic of the C—E junction has a negative resistance. Therefore, the eventual C—E voltage after breakdown has a fairly low value. In addition, as distinguished from the case where the C—B junction has been made to simply break down, in the case of the CEO structure since it has a transistor action after breakdown, the CEO structure has a far lower impedance than in the case of the C—B junction. Accordingly, if the CEO structure of the transistor is utilized as a protective element against electrostatic destruction as is the case with the present invention, when static electricity has been applied thereto, the protective element is hardly destroyed because heat generation in itself is little owing to the low voltage thereacross after breakdown, and also it has an advantage that its capability of absorbing electrostatic energy is large owing to its low impedance. In this way, a monolithic IC having excellent quality in which electrostatic destruction would hardly occur, can be provided by applying the CEO structure of the transistor that has a strong durability against electrostatic destruction and a large capability of absorbing electrostatic energy, to a protective element against electrostatic destruction.

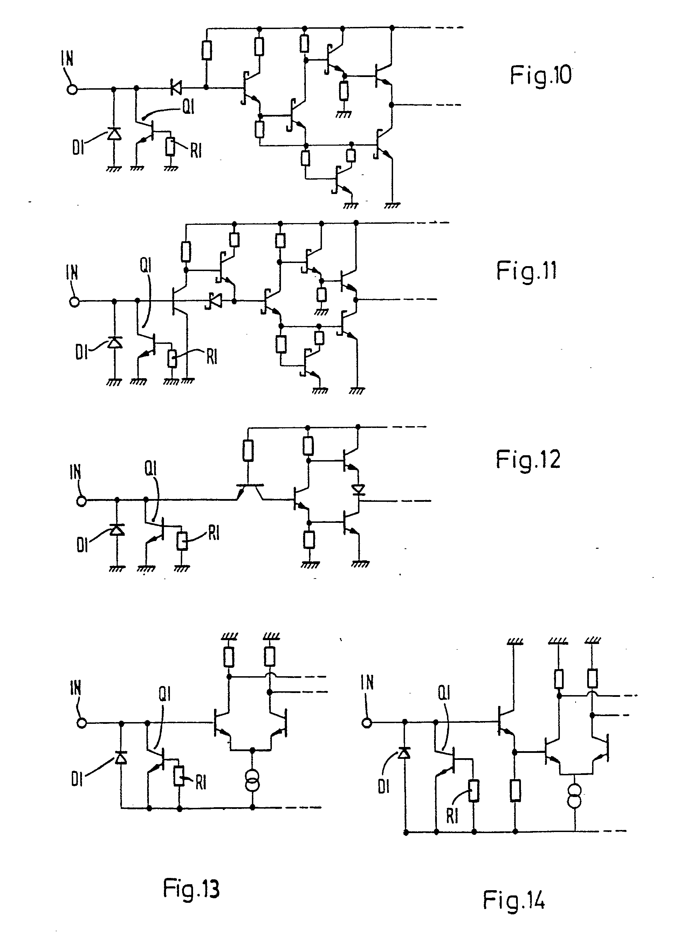

In a transistor having a CEO structure, sometimes it may happen that its breakdown point has various values due to varieties of a diffusion process and/or fluctuations in manufacture and often it cannot meet the rating input withstand voltage value. In order to overcome this difficulty, it is proposed not to open the base of the transistor QI but instead to connect the base to a ground terminal GND through a resistor RI as shown in Fig. 9. Since this resistor RI is provided for the purpose of compensating a leakage current through the C—B junction of the transistor QI, its resistance value could be varied over a wide range of several hundreds to several tens kΩ without necessitating a high precision. By taking such measures, the initial breakdown point becomes approximately equal to that of the C—B junction, so that it can well meet the rating input withstand voltage value, and further, since the eventual voltage after breakdown is exactly identical to that in the case of the CEO structure, with regard to the protective effect against electrostatic rupture, the protective circuit shown in Fig. 9 is quite the same as the transistor having the CEO structure.

Detailed examples of the present invention will be shown in Figs. 10 to 15.

It is to be noted that a diode DI appearing in Figs. 10 to 15 is a collector-substrate junction diode (C—S diode) that is parasitically associated in parallel to a transistor in the case of an IC structure as discussed previously. In the case where the circuit to have its input protected from electrostatic destruction is a DTL (Diode Transistor Logic) or a TTL (Transistor Transistor Logic) illustrated in Figs. 10, 11 and 12, since it is possible to make this parasitic diode have the function of an input low-level clamping diode which is a general standard of a DTL or TTL, the electrostatic protective circuit has an additional advantage that when used at the input of a DTL or TTL, there is no need to separately provide an input clamping diode. In addition, as a matter of course, the protective circuit against electrostatic destruction according to the present invention is applicable not only to the DTL and TTL input circuits as illustrated in Figs. 10, 11 and 12, but also to the case where the circuit to have its input protected is an ECL (Emitter Coupled Logic) as illustrated in Figs. 13 and 14. The protective circuit according to the present invention is also applicable to a circuit employing MOS transistors as shown in Fig. 15.

As described in detail above, according to the present invention it is possible to realize a monolithic integrated circuit having excellent quality in which electric destruction would hardly occur, and therefore, the effect of protecting an integrated circuit against electrostatic destruction according to the present invention is quite remarkable.

### Claim

An integrated circuit comprising a semiconductor substrate (21), an input terminal (IN), an input circuit (logic circuit) formed on said substrate and connected to receive an input signal from said input terminal, and a bipolar transistor (Q1) having its collector-emitter current path coupled between said input terminal and a reference voltage terminal (GND) to form a protective device for discharging an excessive voltage applied to said input terminal, wherein said bipolar transistor (Q1) is formed in said substrate (21) by a collector region (23) and an emitter region (26) of a first conductivity type and a base region (25) of a second conductivity type separating said collector and emitter regions, said emitter region (26) being formed in said base region (25), said base region (25) being formed in said collector region (26), characterized in that said collector region (23) forms a PN-junction with the substrate (21) to form a clamping diode (DI) connected in parallel to said bipolar transistor.

### Patentanspruch

Integrierte Schaltung mit einem Halbleitersubstrat (21), einem Eingangsanschluß (IN), einer Eingangsschaltung (logischen Schaltung), die auf dem Substrat ausgebildet ist und so angeschlossen, daß sie vom Eingangsanschluß ein Eingangssignal empfängt, und einem bipolaren Transistor (Q1), dessen Kollektor-Emitter-Stromweg zwischen dem Eingangsanschluß und einem Bezugsspannungsanschluß (GND) geschaltet ist, um eine Schutzvorrichtung zu bilden zum Entladen einer an den Eingangsanschluß angelegten, zu großen Spannung, wobei der bipolare Transistor (Q1) im Substrat (21) gebildet wird durch einen Kollektorbereich (23) und einen Emitterbereich (26) von einem ersten Leitfähigkeitstyp und einem Basisbereich (25) von einem zweiten Leitfähigkeitstyp, der den Kollektor- und Emitterbereich trennt, wobei der Emitterbereich (26) im Basisbereich (25) ausgebildet ist und der Basisbereich (25) im Kollektorbereich (26), dadurch gekennzeichnet, daß der Kollektorbereich (23) einen PB-Übergang mit dem Substrat (21) bildet, um eine Klemmdiode (DI) zu bilden, die parallel zum Bipolartransistor geschaltet ist.

### Revendication

Circuit intégré comprenant un substrat en semiconducteur (21), une borne d'entrée (IN), un circuit d'entrée (circuit logique) formé sur le substrat et connecté de manière à recevoir un signal d'entrée en provenance de la borne d'entrée, et un transistor bipolaire (Q1) ayant son trajet du courant émetteur-collecteur couplé entre la borne d'entrée et une borne de tension de référence (GND) de manière à former une dispositif de protection pour la décharge d'une tension excessive appliquée à la borne d'entrée, dans lequel le transistor bipolaire (Q1) est constitué dans le substrat (21) par une région de collecteur (23) et une région d'émetteur (26) d'un premier type de conductivité et par une région de base (25) d'un second type de conductivité séparant les régions de collecteur de d'émetteur, la région d'émetteur (26) étant formée dans la région de base (25), la région de base (25) étant formée dans la région de collecteur (26), caractérisé en ce que la région de collecteur (23) forme une jonction PN avec le substrat (21) de manière à former une diode de verrouillage (DI) montée en parallèle avec le transistor bipolaire.

Fig.1   prior Art

Fig.2

Fig.9

Fig.15

Fig.3

Fig.4

Fig.5

Fig.6

Fig.7

Fig.8

3

Fig.10

Fig.11

Fig.12

Fig.13

Fig.14